Europäisches Patentamt

European Patent Office

Office européen des brevets

(19)

(11) EP 1 293 978 A1

## (12) EUROPEAN PATENT APPLICATION

(43) Date of publication:
**19.03.2003 Bulletin 2003/12**

(51) Int Cl.⁷: **G11B 20/18**, H03M 13/00

(21) Application number: **01830577.1**

(22) Date of filing: **10.09.2001**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **STMicroelectronics S.r.l.**
**20041 Agrate Brianza (Milano) (IT)**

(72) Inventor: **Brenna, Filippo**
**20050 Villa Raverio (Milano) (IT)**

(74) Representative: **Bosotti, Luciano et al**
**c/o Buzzi, Notaro & Antonielli d'Oulx**
**Via Maria Vittoria 18**
**10123 Torino (IT)**

### (54) Coding/decoding process and device, for instance for disk drives

(57) The signals that are to be transferred, i.e., written (161) and/or read (17), with respect to the sectors of a storage medium, such as a hard disk, are encoded by using at least two error-correction codes (12, 14). Two error-correction codes (ECCs) are used of the Reed Solomon type, namely an inner code (12) and an outer code (14). At the encoded level, the user data are organized in a matrix structure comprising a first set of data sectors (for example, sixteen data sectors) and are encoded, respectively, by means of the inner code (12) in the horizontal direction of the matrix and by means of the outer code (14) in the vertical direction of the matrix. The redundancy of the outer code (14) is organized in a second set of redundancy sectors, which comprises, for example, two redundancy sectors, written and/or read with respect to said storage medium as the sectors of said first set.

Fig_1

**Description**

Field of the invention

The present invention relates to encoding/decoding techniques and has been developed with particular attention paid to its possible use in the context of hard disk drives.

Even though in the sequel of the present description reference will be made mainly to this particular application, the solution according to the invention can in any case be successfully adopted in any applicational context (for example, storage of data, including audio/video signals, on media of various types) in which the same problems and requirements arise.

Description of prior art

The information data that are to be "transferred" (i.e., written and/or read) with respect to a storage medium, such as a hard disk, are organized in concentric circular tracks. Each track on the disk is partitioned into sectors (which identify the minimum amount of writeable user data), both of the "servo" type and of the "data" type.

Servo sectors contain information about the position co-ordinates on the disk surface and have the purpose of providing for the read/write head a correct reference for it to be properly positioned on the data sector which is to be read/written.

Track partitioning usually envisages that four or five data sectors (D) are set between two servo sectors (S) .

Each data sector comprises the following fields:

- preamble field: this has the function of adjusting the control loops (gain, offset, timing, etc.) in the read/write channel before each corresponding operation;
- sync-mark field: this has the function of identifying with very high reliability the start of user data, in order to set the read/write channel detector (this is usually a Viterbi decoder) in its initial state;
- user-data field: this is the (analog) waveform carrying the user information proper;
- parity field: an error correction code (ECC) is used which comprises redundancy symbols calculated on and added to the data field in order to recover with very high reliability any possible corrupted information symbols by means of an error correction coding technique (usually a Reed Solomon code is used); and
- initial and final pad fields: these are empty fields which are used in order to obtain a safety margin against jitter when locking on sectors (initial pad) and in order to ensure enough time to flush decoded data out of the memory of the read/write channel (final pad).

The standard notation for representing Reed Solomon (hereinafter, briefly, RS) codes envisages designating as RS(n, k, d) a code in which:

- n is the block length of the code, or the total number of data and parity symbols of which a codeword is made up;
- k is the number of user-data symbols of which a codeword is made up; and
- d is the minimum distance of the code.

Since RS codes are maximum distance separable codes, it follows that:

- $n — k = d — 1$ is the total amount of redundancy symbols added to the user-data symbols in order to build a codeword;
- $t =(d - 1)/2$ is the maximum error correction capability of the code; this means that the code is able to recover at the most t errors in a codeword.

RS codes are non-binary codes, which means that their algebra is defined in Galois Fields (GFs) of order greater than 2 (binary field). In particular, the RS codes that are currently most widely used have symbols of m = 8 bits (1 byte), that is, their algebra is defined in $GF(2^8)$.

RS codes are linear codes and are completely described by their generator polynomial G(x) and by their block length "n".

Starting from the generator polynomial G(x) and assuming a systematic encoding procedure, RS codewords are obtained from the information symbols in $GF(2^m)$ according to the following polynomial formula:

$$c(x) = x^{n-k}i(x) + R_{G(x)}[x^{n-k}i(x) ]$$

where:

- c(x) is the polynomial representation of the RS codeword in which unaltered information symbols occupy polynomial coefficients of highest order, this meaning that, since the code is systematic, these are the first to be transmitted to the encoder and decoder machines;
- $R_{G(x)}[x^{n-k}i(x)]$ is the parity check part of the RS codeword, obtained as the remainder of the polynomial division between the information polynomial and the generator polynomial of the code; these redundancy symbols occupy the lowest-order polynomial coefficients of c(x); and
- on account of the systematic character of the encoding, the information polynomial is multiplied by the degree of the generator polynomial.

The decoding rule consists in re-encoding the received RS codeword v(x) since

$$R_{G(x)}[v(x)] = R_{G(x)}[x^{n-k}v_i(x)] + R_{G(x)}[v_p(x)] = S(x)$$

where:

- v(x) is the received RS codeword polynomial;
- $v_i(x)$ is the information part of the received RS codeword;
- vp(x) is the parity check part of the received RS codeword;
- $R_{G(x)}[v(x)]$ is the remainder of the polynomial division between the received RS codeword polynomial and the generator polynomial of the code; and
- S(x) is the syndrome polynomial.

Since the syndrome polynomial depends solely upon the error pattern, it is possible to detect and correct the errors by checking the said polynomial. If the received RS codeword is error-free, the syndrome polynomial is zero.

There exist various algebraic techniques for recovering error values (such as the Forney algorithm or the so-called Chien Search), as well as their positions within the RS codeword (Euclid algorithm, Berlekamp-Massey algorithm) starting from the received syndrome values.

The foregoing corresponds to state-of-the-art knowledge and criteria which, as such, do not require any detailed description herein.

RS codes are commonly used today to recover user data bytes ($GF(2^8)$) that are subject to the action of various sources of noise (electronic noise, media noise and thermal asperity events) which are present in the hard-disk channels (or in channels of similar devices).

Traditionally, this kind of data protection has always been considered at a sector level. Consequently, all the efforts aimed at recovering user information have been limited to the goal of recovering the minimum amount of user information that can be written/read to/from the disk.

RS codes prove very powerful in dealing with random errors or errors with burst characteristics which are quite short if compared to the block length of the code. In order to eliminate the correlation between symbols subject to error and to remedy (at a first-attempt level) thermal-asperity events that do not have a particularly long duration, the current practice is to use RS codes subjected to interleaving: if an RS code is able to correct "t" bytes subject to error, the maximum extension of burst error correctable with a 1-way interleaving is (1*t-1)*8+1 bits.

Taking advantage of the fact that a shortened code has a greater error-detection capability than a code that is not shortened, and in order to adapt to the number of user-data bytes in the sector that undergoes interleaving, it is common practice to use RS codes of a shortened type.

For example, the hard-disk controller marketed under the trade name "Hercules 2" by the present applicant envisages the use of 73 user bytes and 12 redundancy bytes, a 7-way (row) interleaving, and a code RS(85, 73, 13) with the capability of correcting 6 errors.

Each row of the sector that undergoes interleaving is an RS codeword which is encoded, as well as decoded, independently of the other words. The part of information of the codeword remains unaltered after the encoding process (apart from the effect of the interleaving which simply reshuffles the positions of the bytes). In other words, systematic encoding of the RS codes is used since the operating approach reduces the complexity of the decoding process.

It is also possible to follow approaches of a different type, with consequent different effects on the corresponding hardware in terms, for example, of number of ports, speed, power absorption, etc. It is likewise possible to adopt different strategies both as regards the algebraic structure of the code (characteristics of minimum distance) and as regards the decoding strategies.

Further information on the state of the art can be obtained, for instance, from the documents US-A-5 392 290, US-A-5 844 919, US-A-5 974 580, and US-A-6 048 090.

The last three documents cited refer to the activity of the company Cirrus Logic Inc. and regard solutions adopted for the calculation and updating of syndromes in order to save on the processing time, in particular using the cyclic-redundant-code (CRC) field in order to validate the successful outcome of the corrections made. The aforesaid solutions are based upon a product-type code performed on the entire track of the disk, and this involves a very high number of sectors and the need to have available an on-board storage capacity which is necessarily very high. The sectors are subjected to interleaving, and the power of recovery in the presence of phenomena of thermal asperity is in practice that of a completely corrupted sector, or else of three sectors corrupted in one third of their length (in the best of cases). The CRC field is used carrying out a final check before the sector is sent to the host computer. Decoding is not of the iterative type.

Object and summary of the present invention

The purpose of the present invention is to provide an encoding/decoding solution having characteristics that are further improved with respect to the aforesaid known solutions.

According to the present invention, the above purpose is achieved thanks to a process having the characteristics specifically referred to in the claims which follow. The invention also regards the corresponding device.

In brief, the solution according to the invention is based upon a product-type encoding (with the use of two RS codes) performed preferably on a small number of sectors (typically, 16 user-data sectors and two redundancy sectors), which reduces in a determining way the amount of on-board memory required. The sectors are not subjected to interleaving in the strict sense, since there is a single interleaving and preferably the operation is carried out in $GF(2^{10})$ or in $GF(2^{12})$, which gives rise to 10-bit or 12-bit symbols. The power of recovery of phenomena of thermal asperity is two completely corrupted sectors, or else four sectors that are corrupted in one half of their length, or else six sectors that are corrupted in one third of their length, and so forth (in the best of cases). The CRC field is exploited to carry out a test designed to generate very reliable erasure flags. Decoding may be of an iterative type, thus proving much more powerful.

Detailed description of the annexed drawings

The present invention will now be described, purely by way of non-limiting example, with reference to the attached drawings, in which:

- Figure 1 illustrates, in the form of a block diagram, the general structure of a read/write device according to the invention;
- Figure 2 is a schematic representation of the organization of the data of the error-correction code according to the invention;
- Figures 3 and 4 illustrate, in the form of flowcharts, the decoding strategy, respectively of the inner code and the outer code, adopted in the solution according to the invention; and
- Figure 5 illustrates, by way of general reference, the decoding criteria according to "turbo" modalities of an RS product code.

Detailed description of an exemplary embodiment of the invention

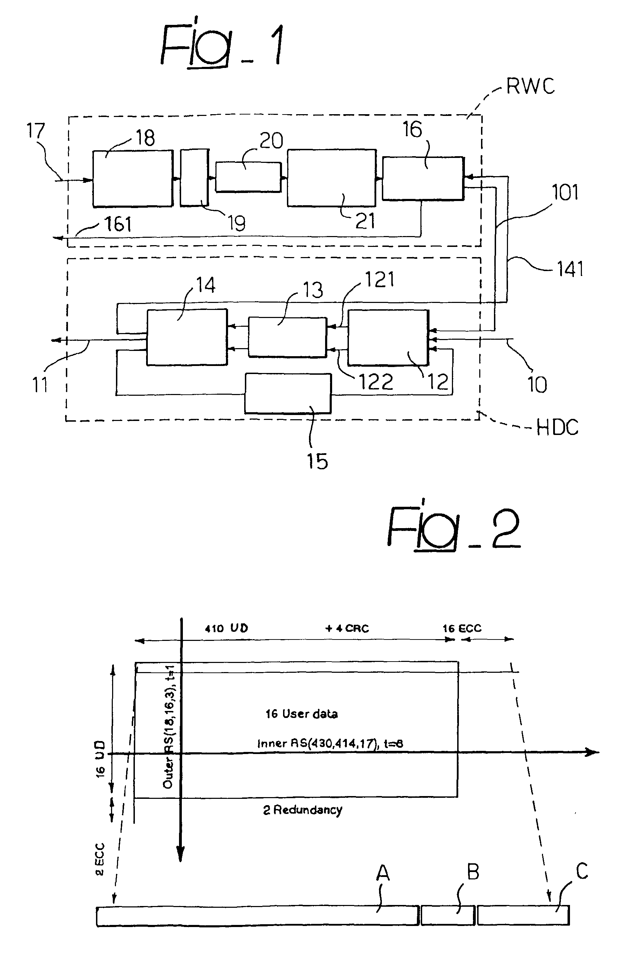

The block diagram of Figure 1 illustrates the general structure of a circuit which can operate according to the invention. This is preferably a circuit designed to be integrated, in a particularly preferred way, as a monolithic integrated circuit and on a single chip. A circuit of this kind can perform the function of controller (hard-disk controller - HDC) and of read/write channel (RWC) for a hard disk, cooperating with the corresponding host computer (not illustrated).

The reference numbers 10 and 11 respectively designate the lines on which the data signals coming from the host and the data signals to be sent to the host propagate.

The reference number 12 designates an RS encoding/decoding module which generates the "inner" code of the encoding scheme according to the invention.

The reference number 13 designates a block having the function of interleaver/de-interleaver which operates according to a row-by-column scheme and is designed to co-operate with a further RS encoding/decoding module 14 which implements the "outer" code of the encoding scheme according to the invention.

Finally, the reference number 15 designates a further block which has the function of interleaver, this block also being set between the modules 12 and 14 in a configuration complementary to that of the module 13.

The modalities of interaction between the various modules 12 to 15 comprised in the encoding/decoding unit that constitutes the core of the device according to the invention are represented in the form of lines and arrows in the diagram of Figure 1. These modalities will, on the other hand, appear evident to persons skilled in the sector on the basis of the ensuing detailed description.

During the encoding/writing stage, the data coming from the host unit on the line 10 are subjected to encoding (according to criteria that will be described in greater detail hereinafter) and exit on an output line 141 to be sent to the RWC module, which functions as an interface with the recording medium (hard disk) proper.

In a dual way, during the reading/decoding stage, the signals coming from the recording medium and processed by the RWC module arrive, on a line designated by 101, at input to the module 12 and are to be transmitted to the unit working as a host on the output line, designated by 11.

In the exemplary embodiment herein illustrated, the RWC module in the first place comprises a module 16 (the presence of which is, on the other hand, optional) which works as a low-propagation line code (or modulation code), from which there exits directly, on a line designated by 161, the writing signal to the recording medium.

During the reading stage, a processing chain comes into play, which receives, on a line 17, the reading signal coming from the recording medium.

The aforesaid processing chain comprises an analog conditioning unit 18 which performs the functions of:

- variable-gain amplifier (VGA);
- magneto-resistive head asymmetry (MRA) cancellation unit, having the function of offsetting the phenomenon - which is characteristic of magneto-resistive reading heads - of presenting an asymmetrical response of the positive edges to the negative edges of the reading signal; and
- low-pass filter (LPF).

The output signal from the conditioning unit 18 undergoes analog-to-digital conversion in a converter 19 to be subsequently filtered in a filter 20, which is usually a finite-impulse-response (FIR) filter, and is then sent on to the input of a detector 21, typically consisting of a Viterbi detector. The signal thus obtained is transferred through the module 16 to the module 12 by means of the line designated by 101.

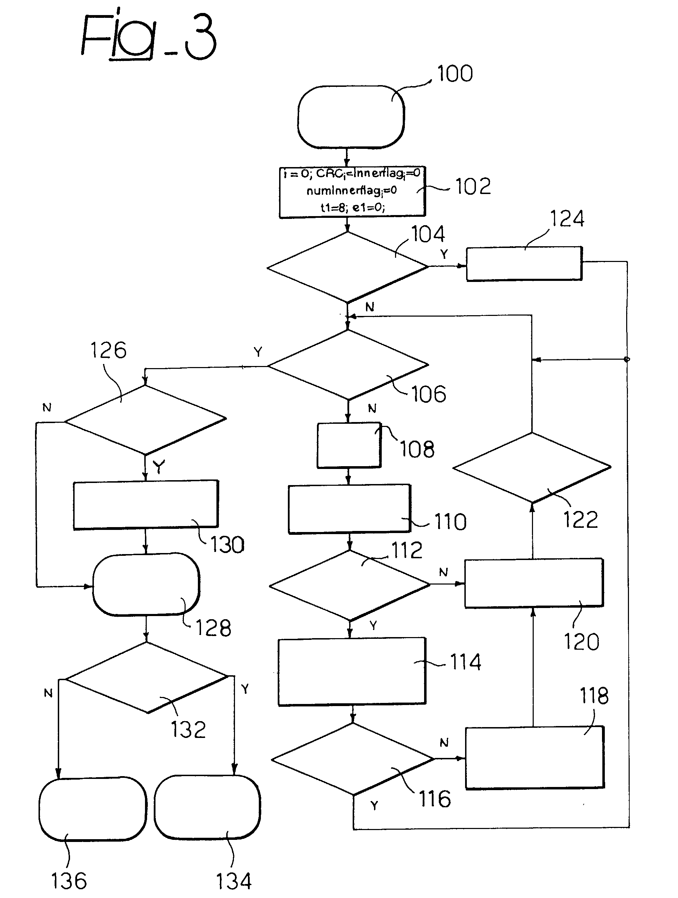

The diagram of Figure 2 shows the user-data symbols ordered according to a matrix structure of sixteen user-data sectors and two redundancy sectors (of course, even though this is currently a choice that is considered preferential, the choice of operating on sixteen sectors and two sectors is certainly not imperative for the purposes of implementing the present invention) encoded on the basis of the error-correction code both in the horizontal direction and in the vertical direction.

Encoding in the horizontal direction is the one that has been called "inner" code with reference to the diagram of Figure 1 (module 13). Vertical encoding is instead the one that has been called "outer" code (module 14 in Figure 1).

The redundancy of the outer code is then ordered according to two redundancy sectors written on a disk exactly as for the other sixteen sectors.

Both the codes used for matrix-structure encoding are of the Reed Solomon type with different characteristics of minimum distance, and hence with accordingly different capabilities of error detection and correction.

One of the choices that is considered at present preferential is the following:

- inner code RS(1024, 1008, 17) with t = 8
- outer code RS(1024, 1022, 3) with t = 1.

Since it is less complex to implement and more efficient in terms of error detection/correction capability, the choice of a single codeword, corresponding to an entire sector, subjected to interleaving having depth 1 (which virtually means the absence of interleaving), has been adopted for the inner code. For reasons of complexity, the aforesaid codes are preferably chosen of a systematic type, which means that the symbols for the user data in a codeword are not affected by the encoding process. When recourse is made to a single interleaving, in order to adapt the codeword to an adequate number of user-data symbols it is important to choose an algebraic field of an order greater than $GF(2^8)$, i.e., an order greater than that of a field having 8-bit symbols.

For this reason, and in order to have greater encoding efficiency, in the currently preferred embodiment the scheme proposed operates in an algebraic field of order $GF(2^{10})$, and consequently 10-bit symbols are used.

An alternative which is certainly advantageous is that of working in $GF(2^{12})$, using 12-bit symbols, a choice which can prove convenient for at least three reasons:

i) 12 is a multiple of four (12 is 3 nibbles) and is thus closer to the typical 8-bit form (2 nibbles): in hardware terms it is easier to operate with multiples of 4 bits;

ii) working in $GF(2^{12})$ makes it possible to have greater block lengths (for an RS the block length would be $2^{12} = 4096$), and hence greater encoding efficiency; and

iii) since a sector always has a fixed length (the usual 512 equivalent bytes), working in $GF(2^{12})$ makes it possible to have an even more shortened code than working in $GF(2^{10})$.

In fact:

one sector ≈ 512 bytes (4096 bits)
≈ 409 ten-bit symbols (block length, 1024) → 1024 shortened to 409
≈ 340 twelve-bit symbols (block length, 4096) → 1024 shortened to 340.

The more a code is shortened, the higher its detecting capacity.

Exploiting the fact that a shortened code has a greater capacity for detecting the error than an entire code, the two RS codes as identified above are, still more preferably, subjected to shortening in such a way as to use:

- as inner code, a code RS(430, 414, 17); and

- as outer code, a code RS(18, 16, 3).

In this way it is possible to maintain the same properties in terms of distance (capacity for error correction and detection the error) as the original codes.

Finally, in order to render the decoding strategy flexible so that it can adapt to different conditions of environmental noise, both error corrections and erasure corrections are taken into account. Consequently, both the inner code and the outer code are implemented by means of RS decoders with full complexity.

In particular, in the diagram of Figure 2, the 410 user-data symbols (UDSs), plus the 4 CRC symbols and the 16 ECC symbols are indicated at the top. The solid-line rectangle indicates the 16 data sectors below which there are the two redundancy sectors.

The band at the bottom again represents a user-data sector (410 ten-bit symbols, designated as a whole by A), as well as the 4 CRC symbols (designated by B) and the 16 ECC symbols (designated by C).

As regards the encoding balance, the symbols of the ECC-block matrix, each of which has ten bits, are made up of 18 rows and 430 columns. Each row corresponds to one sector of the disk and comprises 410 user-data symbols (the standard 512-byte user sector), 4 CRC symbols for error detection alone (again used in standard approaches) and 16 ECC symbols for error detection/correction.

Each column is made up of 16 user-data symbols and 2 ECC symbols for error detection/correction.

The total amount of user-data symbols and redundancy symbols in a scheme of this sort is respectively 6560 and 1116, which corresponds to 70 redundancy symbols per sector, with an encoding factor of 14%, a value which is altogether in line with current values.

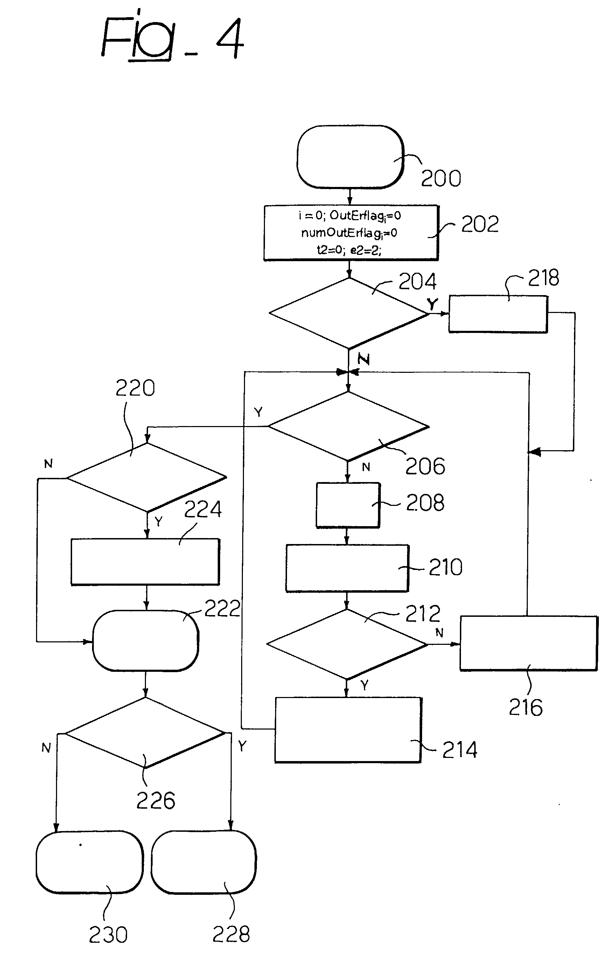

The flowcharts of Figures 3 and 4 illustrate the decoding strategy, respectively for the inner code (Figure 3) and for the outer code (Figure 4).

With reference first to the flowchart of Figure 3, after a start-of-decoding step, designated by 100, in the step designated by 102 the values are initialized according to the criteria exemplified in the corresponding block in the figure.

Step 104 is a choice step designed to start the iterative decoding scheme according to the number of data sectors used (sixteen, in the example of embodiment illustrated).

In practice, the test of step 104 corresponds to verifying that the second inner decoding is in progress (second iteration; i.e., the turbo function is set) and that the number of erasure flags generated by the outer code (at the first iteration) is smaller than or equal to the number of flags that can be handled by the inner code.

In practice, if the turbo function is not set (i.e., it is the first time that the inner code is working, that is, the first iteration), the inner code corrects 8 errors and 0 erasures: $t1 = 8$; $e1 = 0$.

If the turbo function is set, the inner code can correct up to 16 erasure flags (which are supplied to it by the outer code). If the outer code supplies to the inner code $m \leq 16$, then the inner code can handle them; consequently, the inner code considers and corrects only erasures, adopting the strategy $t1 = 0$, $e1 = 16$. If, instead, the outer code supplies to the inner code $m > 16$, then the inner code cannot handle them (this is outside the capabilities of the code), and therefore does not consider them and corrects only errors, hence adopting the strategy $t1 = 8$; $e1 = 0$, i.e., the same strategy as when the turbo function is not set, namely the first iteration of the inner code.

Following the main path of the flowchart (output NO from step 104), the steps designated by 106 and 108 respectively correspond to the verification of the fact that all the rows have been decoded (choice step 106) and to the progressive increase of the corresponding index i.

Step 110 corresponds to the decoding operation proper at the inner-code level and to calculation of the CRC for the i-th row.

In step 112 it is verified whether the i-th row in question is to be considered correctable.

In the event of output YES from step 112, the system proceeds to step 114 which applies the correction and updates the CRC index. Step 116 is, instead, a choice step in which it is verified whether the current CRC index is equal to zero. In the event of output NO from step 116, the system proceeds to step 118 in which, for k comprised between 1 and $n_{err}$, the correction of order k is erased and the CRC index is updated, and then proceeds to a step 120 in which an erasure flag is generated.

It will be appreciated that step 120 is the same step towards which the system evolves directly in the case where in step 112 it has been verified that the i-th row cannot be corrected.

After a step 122 in which the erasure flag of the i-th row goes to 1=TRUE (the CRC of that row has failed, hence the row has remained affected by error; i.e., errors are still present), at the same time, a counter is increased which counts how many erasure flags the inner code is generating, i.e., how many rows it is detecting as non correctable. If, at the end, the flags generated by the inner code are more than the ones that the outer code can handle, then the outer code will detect this condition by carrying out a check on the counter in question and will "decide" to correct only errors. Hence, the same considerations apply as those made previously in regard to step 104 for the change of strategy for the outer code.

The system then goes back to step 106, a point towards which the system evolves right from the start in the event of output YES from step 104 through a step 124 of change of decoding strategy.

When the iteration proper on the rows is concluded (output YES from step 106), the system proceeds to a further choice step 126 in which it is verified whether the number of erasure flags (which the counter has counted) generated by the inner code is higher than the number that the outer code can handle. At this point:

    i) the outer code will change strategy (Figure 4) ;
    ii) the inner code will erase all the flags put on the rows (since there are too many of them, they are no longer needed, so they are eliminated); this is done in step 130 if step 126 is true.

If there are not too many flags (output NO from step 126), the encoding of the inner code terminates in a step 128.

If, instead, the number of flags is excessive, transition from step 126 to step 128 is via the step 130 described previously. Finally, step 132 is a step in which it is verified whether the number of flags is greater than zero.

If the answer is YES, the system proceeds to the operation of outer decoding (which will be illustrated in what follows with reference to Figure 4) through a step 134.

In the case, instead, of output NO from step 132, the system proceeds to a step 136 in which the error-correction decoding is concluded.

The strategy of decoding of the outer code, which is represented in the flowchart of Figure 4, is on the whole similar, and from certain points of view slightly simplified, compared to that of the inner code described previously.

Also in this case, after a starting step 200 and an initialization step 202, there is started, through a choice step 204 in which it is verified whether the number of erasure flags generated by the previous inner decoding can be managed by the outer code.

If the outer code can handle the number of erasure flags (test = N), then the system proceeds to step 206; otherwise (Y), the strategy will have to be changed: too many flags, hence only errors will be corrected (t2 = 1; e2 = 0) .

Next, an iterative strategy is set under way which, through the sequence of the choice step 206 and a step 208 of increment of the corresponding index, examines the various columns.

Whenever a given column is examined, after step 208 a step 210 of outer decoding proper of the i-th column is performed, which is followed by a choice step 212 in which it is verified whether the column can be corrected or not.

In the event of output YES from step 212, the system proceeds to a step 214 in which the correction is applied and the CRC index is updated, after which the system returns to step 206.

In the case where in step 212 it is verified that the i-th column cannot be corrected, the system proceeds to a step 216 where an erasure flag is generated before the system returns to step 206. The system evolves to the same point, namely to step 206, after first performing a change-of-strategy step 218, in the event of output YES from step 204.

Once processing of all the columns has been completed (output YES from step 206), the system proceeds to a step 220 where it is verified whether the number of flags is excessive.

Also in this case, if this number is not excessive, the system proceeds directly to a step 222 in which the outer decoding is concluded.

In the event, instead, of output YES (presence of too many flags) from the choice step 220, transition to step 222 is via a step 224 which basically constitutes a homologous step of step 130 of Figure 3.

As in the case of the flowchart of Figure 3, the step of completion of outer decoding 222 is followed by a step 226 in which it is verified whether the number of outer flags is greater than zero.

If the answer is affirmative, turbo decoding proper is started (step 228). If the answer is negative, the system acknowledges the end of ECC decoding (step 230).

The flowcharts of Figures 3 and 4 make it possible to realize that the erasure flags of the inner code are generated under the control of the available CRC check, this being a function which assumes particular importance in the context of the present invention, in so far as it represents an altogether innovative use of the CRC.

Should the said check fail, any possible correction that has just been applied (with a very high risk of miscorrection) is erased by imposing the erasure flag for the corresponding row.

For either code, if the number of erasure flags received exceeds the capacity of erasure correction as the only reliable strategy, the error correction alone, and not the erasure correction, is chosen.

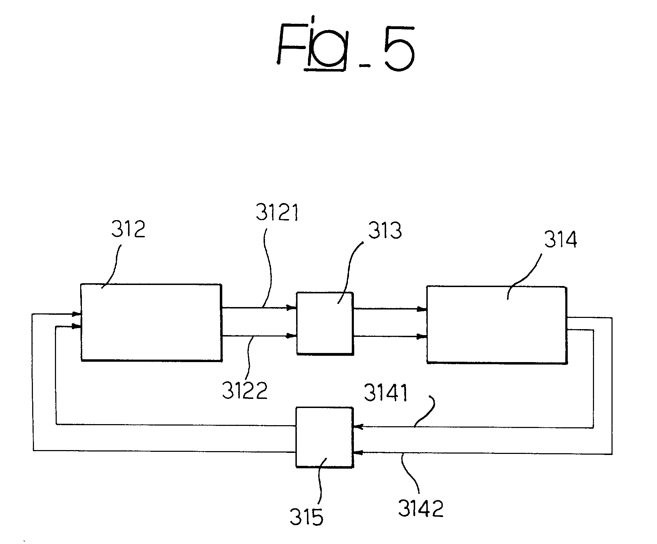

The diagram of Figure 5 (the functional correspondence of the modules of which with the modules 12 to 15 represented at the bottom of Figure 1 may be readily appreciated) represents the execution of the turbo-decoding operation.

In particular, in the diagram of Figure 5, the reference number 312 designates decoding of the inner code with t = 8 or e = 16, which means that the code can correct all combinations of errors (v) and erasures (e) in such a way that the minimum distance of the code dmin - 1 $\geq$ 2*V + e. This means that it could even be decided to correct with the inner code (dmin = 17) 7 errors and 2 erasures, or 6 errors and 4 erasures, etc.

In the case of the example to which the diagram of Figure 2 refers, there are supplied at output, on lines 3121 and 3122 (c.f. also the lines 121 and 122 of the diagram of Figure 1), respectively the soft-type information (namely, the erasure flags) and the hard-type information (namely, the data symbols) directed to the interleaving function 313 (c.f. also the module 13 in Figure 1).

The latter function in turn feeds the outer-decoding function 314 (which, in the present case, envisages the choice of the values t = 1 or e = 2).

This function supplies, on outputs virtually identifiable as lines 3141 and 3142, respectively the soft-type information (erasure flags) and hard-type information (data symbols) to the de-interleaving function 315 (c.f. also the module 15 in the diagram of Figure 1).

In practice, turbo decoding starts when the outer ECC code produces at least one erasure flag at the first iteration. This means that the ECC matrix has left a few error symbols. Consequently, further decoding attempts are required in order to recover the user-data symbols completely.

In general, the iterations of turbo decoding are stopped when at least one of the following conditions is met:

- all the CRC checks on the rows (sectors) are positive; and/or
- the maximum number of iterations allowed has been reached.

The latter number is chosen in general as a reasonable compromise between requirements of speed and power absorption in the light of the performance in terms of error factor.

In view of the matrix organization and of the capability for correction of the inner and outer ECC codes that have just been described, it is possible to recover at the most two completely corrupted sectors by means of a single iteration of the decoding strategy.

Consequently, if a condition, which is certainly very severe, is assumed in which a thermal-asperity event has involved and rendered unusable an entire sector, with a single operation it is possible to remedy completely two events of this type in a cluster of sixteen sectors.

Tests carried out by the present applicant show that, given the current performance of RW-channel chips (a soft-error factor of $10^{-3}$), it is possible to ensure the performance in terms of error factor on the symbol required for hard-disk drives by using the two decoding processes, namely the inner one and the outer one (single-shot decoding), so rendering a turbo-type strategy necessary only in the presence of error factors on the soft-type bit greater than $10^{-3}$, or else in the presence of catastrophic error events of the type generated by one or more thermal asperities.

The same tests have shown that it is generally preferable to get the inner code to correct both the errors and the erasures right from the first iteration. This choice appears to be advantageous only if there is the possibility of having available erasure flags coming from the RW channel that are particularly reliable. This prevents the solution according to the invention from being adversely affected more by phenomena of miscorrection and misdetection than by the disk noise proper. The above danger is likely to be due to the fact that the probability of having rows not signalled as erasures by the inner code even if they correspond to corrupted rows (sectors) is somewhat high, even though it is far lower than the probability of failing an ECC block.

Another solution for containing the aforesaid undesired effect is to use the CRC field as a very reliable way for detecting incorrect rows.

In any case, the solution that envisages the use of the CRC to increase the reliability of the corrections is far more efficient and valid than the solution of using erasure flags supplied by the RW channel.

On the other hand, the above solutions are not mutually exclusive, and it is also possible to adopt a solution deriving from their combination.

The solution of using the CRC for generating erasure flags appears to be very interesting, but it does not rule out the possibility of using both the CRC and the flags generated by the RW channel.

The probability of misdetection on the columns is in any case very low in view of the considerable shortening of the outer code.

The solution according to the invention affords better results in terms of performance using the same amount of redundancy used by currently available architectures. In addition, the solution according to the invention reveals a considerable capacity for improving its performance in the presence of values of signal/noise ratio even lower than those that are currently typical, or in the presence of individual or multiple catastrophic events, such as thermal asperities, thanks to the adoption of turbo strategies.

The solution according to the invention affords the further advantage of being very flexible, in so far as it makes it possible to operate with different decoding strategies in the stage of optimization of the hard-disk system, so that different situations of environmental noise (computer applications or audio/video applications, or consumer applications) can be coped with. The solution is particularly suited for dealing with events of thermal asperity (two completely corrupted sectors which can be entirely recovered). Phenomena of environmental noise are bound to become increasingly serious and frequent in view of the continuous increase in the speed of disk rotation.

Finally, the solution according to the invention does not entail higher complexity in computational terms, in so far as it can use, for instance, an inner RS decoding machine with t = 8 (at present, RS decoders are used with t = 6 with 7 interleaving steps) and an outer RS decoder with t = 1, which is a machine that can be implemented very simply at a hardware level.

In the above connection, the solution according to the invention overcomes the traditional approach of reading/writing the user data at the sector level, by proposing a scheme that is able to operate at a cluster level, i.e., for example, eighteen-sector clusters.

The above approach is particularly suited for audio/video hard-disk applications and in all those contexts in which there are no particular reasons for transferring the data according to units corresponding to single sectors.

Of course, without prejudice to the principle of the invention, the details of construction and the embodiments may vary widely with respect to what is described and illustrated herein, without thereby departing from the scope of the present invention as defined in the annexed claims.

**Claims**

1. A process for encoding/decoding signals transferred with respect to sectors of a storage medium, said sectors comprising user-data sectors and redundancy sectors, the process involving the use of the product of at least two error-correction codes (12, 14) and being **characterized in that**:

   - said at least two error-correction codes (ECC) are Reed Solomon codes and are an inner code (12) and an outer code (14);
   - at the encoded level, said user data are organized in a matrix structure comprising a first set of data sectors (A, B) and are encoded, respectively, by means of said inner code (12) in the horizontal direction of the matrix and by means of said outer code (14) in the vertical direction of the matrix, whilst the redundancy of the outer code (14) is organized in a second set of redundancy sectors (C) transferred with respect to said storage medium as the sectors of said first set (A, B).

2. The process according to Claim 1, **characterized in that** said first set comprises sixteen data sectors (A, B).

3. The process according to Claim 1 or Claim 2, **characterized in that** said second set comprises two redundancy sectors (C).

4. The process according to any one of the preceding claims, **characterized in that** at least one, and preferably both, of said Reed Solomon codes (12, 14) are of the shortened type.

5. The process according to any one of the preceding claims, **characterized in that** said inner code is of the RS(1024, 1008, 17) type, preferably of the RS (430, 414, 17) shortened type.

6. The process according to any one of the preceding claims, **characterized in that** said outer code is a code of the RS(1024, 1022, 3) type, preferably of the RS(18, 16, 3) shortened type.

7. The process according to any one of the preceding claims, **characterized in that** said two codes operate in a Galois field $GF(2^{10})$, with 10 bits per symbol, or else $GF(2^{12})$, with 12 bits per symbol.

8. The process according to any one of the preceding claims, **characterized in that** said matrix comprises a plurality of rows, with each row corresponding to a sector of said medium.

9. The process according to Claim 8, **characterized in that** in said matrix each row comprises, in addition to user data, a first field of error-detection (CRC) symbols and a second field of error-detection/correction (ECC) symbols.

10. The process according to Claim 1 or Claim 9, **characterized in that**, at the encoding level, the codewords undergo a single interleaving.

11. The process according to Claim 9, **characterized in that** it comprises the operation of utilizing said first field of error-detection (CRC) symbols, in the intermediate decoding steps, to generate reliable erasure flags to be used for augmenting decoding itself.

12. The process according to Claim 9 or Claim 11, **characterized in that** said first field of error-detection (CRC) symbols comprises four symbols.

13. The process according to Claim 9, **characterized** in that said second field of error-detection/correction (ECC) symbols comprises sixteen symbols.

14. The process according to any one of the preceding claims, **characterized in that** said matrix comprises a plurality of columns, with each column comprising, in addition to user data, at least one respective field of error-detection/correction (ECC) symbols.

15. The process according to Claim 14, **characterized in that** said respective field of error-detection/correction (ECC) symbols comprises two symbols.

16. The process according to any one of the preceding claims, **characterized in that** said respectively inner code (12) and outer code (14) are concatenated by means of the exchange of soft information (3121, 3141).

17. The process according to Claim 9 and Claim 16, **characterized in that** it comprises the operation of generating soft-information flags for the purposes of concatenating respective inner code (12) and outer code (14) according to said first field of error-detection (CRC) symbols.

18. The process according to Claim 17, **characterized in that** said it comprises the operation of generating said flags in the form of erasure flags.

19. The process according to any one of the preceding claims, **characterized in that** said respective inner code (12) and outer code (14) are concatenated and decoded in iterative form.

20. The process according to Claim 18 and Claim 19, **characterized in that** it comprises the operation of performing, by means of said inner code (12), correction of the errors and, preferably, of the erasures at the first iteration.

21. A device for encoding/decoding signals transferred with respect to sectors of a storage medium, said sectors comprising user-data sectors and redundancy sectors, the device comprising an encoding/decoding unit (12 to 15) operating according to the product of at least two error-correction codes (12, 14) and being **characterized in that**:

- said unit (12 to 15) implements said error-correction codes (ECC) as Reed Solomon codes, of which one is an inner code (12) and the other is an outer code (14);
- said unit (12 to 15) is configured for organizing, at the encoded level, said user data in a matrix structure comprising a first set of data sectors (A, B) and are encoded, respectively, by means of said inner code (12) in the horizontal direction of the matrix and by means of said outer code (14) in the vertical direction of the matrix, whilst said unit (12 to 15) organizes the redundancy of the outer code (14) in a second set of redundancy sectors (C) transferring them (17, 161) with respect to said storage medium as the sectors of said first set (A, B).

22. The device according to Claim 21, **characterized in that** said first set comprises sixteen data sectors (A, B).

23. The device according to Claim 21 or Claim 22, **characterized in that** said second set comprises two redundancy sectors (C).

24. The device according to any one of the preceding claims from Claim 21 to Claim 23, **characterized in that** at least one, and preferably both, of said Reed Solomon codes (12, 14) are of the shortened type.

25. The device according to any one of the preceding claims from Claim 21 to Claim 24, **characterized in that** said inner code is of the RS(1024, 1008, 17) type, preferably of the RS(430, 414, 17) shortened type.

26. The device according to any one of the preceding claims from Claim 21 to Claim 25, **characterized in that** said outer code is a code of the RS(1024, 1022, 3) type, preferably of the RS(18, 16, 3) shortened type.

27. The device according to any one of the preceding claims from Claim 21 to Claim 26, **characterized in that** said two codes operate in a Galois field GF $(2^{10})$, with 10 bits per symbol, or else GF$(2^{12})$, with 12 bits per symbol.

28. The device according to any one of the preceding claims from Claim 21 to Claim 27, **characterized in that** said unit (12 to 15) is configured for organizing said matrix structure as a matrix comprising a plurality of rows, with each row corresponding to a sector of said medium.

29. The device according to Claim 28, **characterized in that** in said matrix each row comprises, in addition to user data, a first field of error-detection (CRC) symbols and a second field of error-detection/correction (ECC) symbols.

30. The device according to Claim 21 or Claim 29, **characterized in that** it comprises at least one interleaver (13) and at least one de-interleaver (15) for subjecting the codewords to row-by-column interleaving and de-interleaving.

31. The device according to Claim 29, **characterized in that** said unit (12 to 15) is configured for utilizing said first field of error-detection (CRC) symbols, in the intermediate decoding steps, to generate reliable erasure flags to be used for augmenting decoding itself.

32. The device according to Claim 29, **characterized in that** said first field of error-detection (CRC) symbols comprises four symbols.

33. The device according to Claim 29, **characterized in that** said second field of error-detection/correction (ECC) symbols comprises sixteen symbols.

34. The device according to any one of the preceding claims from Claim 21 to Claim 33, **characterized in that** said matrix comprises a plurality of columns, with each column comprising, in addition to user data, at least one respective field of error-detection/correction (ECC) symbols.

35. The device according to Claim 34, **characterized in that** said respective field of error-detection/correction (ECC) symbols comprises two symbols.

36. The device according to any one of the preceding claims from Claim 21 to Claim 35, **characterized in that** said unit (12 to 15) comprises exchange lines (3141, 3142) for the exchange of soft information for concatenation of said respectively inner code (12) and outer code (14).

37. The device according to Claim 29 and Claim 36, **characterized in that** said unit (12 to 15) generates soft-information flags for the purposes of concatenating said respective inner code (12) and outer code (14) according to said first field of error-detection (CRC) symbols.

38. The device according to Claim 37, **characterized in that** said unit (12 to 15) generates said flags in the form of erasure flags.

39. The device according to any one of the preceding claims from Claim 21 to Claim 37, **characterized in that** said unit (12 to 15) is configured for decoding said respective inner code (12) and outer code (14) in iterative form.

40. The device according to Claim 38 and Claim 39, **characterized in that** said unit (12 to 15) is configured for performing, by means of said inner code (12), correction of the errors and, preferably, of the erasures at the first iteration.

## Fig_1

## Fig_2

# Fig.3

# Fig _ 4

```
                          ( 200 )
                             |
            ┌────────────────────────────────┐
            │ i = 0; OutErflag_i=0           │ ── 202
            │ numOutErflag_i=0               │
            │ t2=0; e2=2;                    │
            └────────────────────────────────┘
                             |
                          204 ◇ ──Y──> [ 218 ]
                             |N              |
                             |               |
        220                  ↓               |
         ◇ ──Y── 206 ◇ ──N── [ 208 ]        |
        N|              |      |             |
         |              ↓      ↓             |
    224 [     ]      [ 210 ]                 |
         |              |                    |
    222 ( )          212 ◇ ──N── [ 216 ]
         |              |Y
    226 ◇            [ 214 ]
     N/ \Y
   (230)(228)
```

Fig_5

EP 1 293 978 A1

**European Patent Office**

**EUROPEAN SEARCH REPORT**

Application Number

EP 01 83 0577

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,X | US 5 974 580 A (KATO KEISUKE ET AL) 26 October 1999 (1999-10-26) * column 6, line 14 - line 29; figure 2 * | 1-3, 8-23, 28-40 | G11B20/18 H03M13/00 |
| Y | * column 9, line 46 - line 55 * | 4-7, 24-27 | |
| Y | CLARK G C ET AL: "ERROR CORRECTION CODING FOR DIGITAL COMMUNICATIONS" ERROR CORRECTION CODING FOR DIGITAL COMMUNICATIONS, NEW YORK, PLENUM PRESS, US, 1981, pages 214-219, XP002181186 * figures 2-12 * | 4,24 | |
| Y | WOLF J K: "Efficient circuits for multiplying in GF(2**m) for certain values of m" DISCRETE MATHEMATICS, NORTH-HOLLAND PUBLISHING CO., AMSTERDAM, NL, vol. 106/107, 1 September 1992 (1992-09-01), pages 497-502, XP002098754 ISSN: 0012-365X * page 497, line 1 - page 502, last line * | 5-7, 25-27 | TECHNICAL FIELDS SEARCHED (Int.Cl.7) H03M G11B |
| D,A | US 6 048 090 A (ZOOK CHRISTOPHER P) 11 April 2000 (2000-04-11) * abstract * | 1,21 | |
| D,A | US 5 844 919 A (GLOVER NEAL ET AL) 1 December 1998 (1998-12-01) * abstract * | 1,21 | |
| D,A | US 5 392 290 A (GREENBERG RICHARD ET AL) 21 February 1995 (1995-02-21) * abstract * | 1,21 | |

The present search report has been drawn up for all claims

| Place of search | Date of completion of the search | Examiner |
|---|---|---|
| THE HAGUE | 22 March 2002 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

15

# EP 1 293 978 A1

## ANNEX TO THE EUROPEAN SEARCH REPORT
## ON EUROPEAN PATENT APPLICATION NO.

EP 01 83 0577

This annex lists the patent family members relating to the patent documents cited in the above-mentioned European search report.
The members are as contained in the European Patent Office EDP file on
The European Patent Office is in no way liable for these particulars which are merely given for the purpose of information.

22-03-2002

| Patent document cited in search report | | Publication date | Patent family member(s) | | Publication date |
|---|---|---|---|---|---|
| US 5974580 | A | 26-10-1999 | AU | 8504798 A | 16-02-1999 |
| | | | EP | 0998791 A1 | 10-05-2000 |
| | | | JP | 2001511615 T | 14-08-2001 |
| | | | WO | 9905793 A1 | 04-02-1999 |
| US 6048090 | A | 11-04-2000 | JP | 11055129 A | 26-02-1999 |
| US 5844919 | A | 01-12-1998 | NONE | | |
| US 5392290 | A | 21-02-1995 | DE | 69315270 D1 | 02-01-1998 |
| | | | DE | 69315270 T2 | 28-05-1998 |
| | | | EP | 0581362 A1 | 02-02-1994 |
| | | | JP | 2547943 B2 | 30-10-1996 |
| | | | JP | 6267192 A | 22-09-1994 |

EPO FORM P0459

For more details about this annex : see Official Journal of the European Patent Office, No. 12/82